# EUROPÄISCHE PATENTANMELDUNG

(11) **EP 1 524 329 A1**
(43) Veröffentlichungstag der Anmeldung: **20.04.2005**
(21) Anmeldenummer: 03405753.9
(22) Anmeldetag: 17.10.2003
(51) Int. Cl.: C23C 14/32, C23C 14/34, H01J 37/34

(54) **Modulare Vorrichtung zur Beschichtung von Oberflächen**

(71) Anmelder: Platit AG, 2540 Grenchen (CH); Pivot a.s., 78701 Sumperk (CZ)
(72) Erfinder: Tibor, Cselle, 2540 Grenchen (CH); Mojmir, Jilek, 787 01 Sumperk (CZ)
(74) Vertreter: EGLI-EUROPEAN PATENT ATTORNEYS

(57) **Zusammenfassung**

Um eine Vakuumkammer zum Beschichten von Gegenständen (10), in der ein physikalisches Abscheideverfahren (PVD) durchgeführt werden kann, modular mit Kathoden bestücken zu können, wird vorgeschlagen, eine Vielzahl von Aufnahmeeinrichtungen vorzusehen, in die jeweils mehrere Kathoden angeordnet werden können. Eine erste Aufnahmeeinrichtung (30) zur Aufnahme von einer oder mehrerer Kathoden (40, 42, 44, 46) ist im wesentlichen in der Mitte der Vakuumkammer (20) und zwei weitere Aufnahmeeinrichtungen (32, 34) zur Aufnahme von zumindest jeweils einer Kathode (48, 50, 52, 54) sind türartig am Rand der Vakuumkammer (20) vorgesehen.

## Beschreibung

Die vorliegende Erfindung betrifft eine modulare Vorrichtung zur Beschichtung von Oberflächen von Gegenständen (Substraten) durch das physikalische Aufbringen von Material im Vakuum (PVD) mit Hilfe eines Lichtbogens oder mehreren Lichtbögen, einschliesslich der Beschichtung mit mehreren Schichten auf unterschiedlicher Weise, die im folgenden modulare, dedizierte Beschichtung genannt wird. Des weiteren betrifft die Erfindung ein System mit einer solchen modularen Vorrichtung.

Schon aus der WO-A-02/50865 ist eine Vorrichtung bekannt, durch eine Beschichtung auf einem Werkstück durch das Abscheiden von typischerweise zwei in etwa zylindrischen Targets bewirkt wird, wobei dann das Material auf dem Werkstück niederschlägt und so eine Schicht ausbildet. In der WO-A-02/50865 wird dazu vorgeschlagen, das Target durch eine bestimmte Magnetfeldanordnung so auszubilden, dass ein gerichtetes Materialabdampfen stattfinden kann und so bestimmte Effekte erzielt werden können.

Aus der EP-A-1357577 ist ein Verfahren dazu bekannt, optimale Effekte der selektiven Beschichtung durchzuführen.

In der Beschichtungskammer sind dabei ein oder mehrere, im wesentlichen zylinderförmig ausgebildete Kathoden angeordnet und mit Hilfe von Magnetquellen wird die Abscheidung des Materials gesteuert. Die Magnetquellen sind dabei vorzugsweise in den Kathoden angeordnet und die Kathode wird gegenüber der Magnetfeldquelle oder die Magnetfeldquelle gegenüber der Kathode verdreht, um so ein gleichmässiges Abtragen des Materials vom Target zu bewirken. Dieses Material wird dann auf den Substraten abgeschieden.

In einer solchen Kammer werden dabei üblicherweise Substrate auf einem Drehteller platziert und - unter Drehung des Teller - sukzessive beschichtet. Nach dem Stand der Technik ist es bekannt, die Kathode z.B. in die Mitte des Drehtellers zu platzieren, um so eine Beschichtung von mehreren Gegenständen in einer Kammer durchführen zu können.

Die beiden vorstehend genannten Patentanmeldungen werden hiermit durch Referenznahme vollumfänglich Inhalt dieser Patentanmeldung.

Eine Anordnung nach der WO-A-02/50865 kann als erfolgreiche Vorrichtung angesehen werden, wenn in etwa stabförmige Gegenstände beschichtet werden sollen. Für diesen Fall wird man eine entsprechende Beschichtungskammer auswählen. Es hat sich aber herausgestellt, dass eine Beschichtungskammer, die für eine Vielfalt von zu beschichtenden Gegenständen geeignet sein soll, vielseitiger sein muss.

Es ist also zunächst einmal die Aufgabe der Erfindung, eine variable Beschichtungskammer bzw. eine variable Anordnung von Beschichtungsmitteln anzugeben, die für auch andere zu beschichtende Gegenstände geeignet und damit variabler ist, als nach dem vorbekannten Stand der Technik.

Die Erfindung löst die Aufgabe durch eine Anordnung nach Anspruch 1. Dabei haben die Massnahmen der Erfindung zunächst einmal zur Folge, dass durch die modulare Anordnung eine Vielzahl von Beschichtungssituationen behandelt werden kann.

Die Anordnung dient zur Aufnahme in ein Beschichtungssystem, welches ebenfalls Gegenstand der Erfindung ist.

Vorteilhafte Ausgestaltungen der Erfindung sind in den abhängigen Ansprüchen angegeben.

Die vorgenannten sowie die beanspruchten und in den nachfolgenden Ausführungsbeispielen beschriebenen, erfindungsgemäss zu verwendenden Verfahrenschritte und die dazugehörigen Elemente unterliegen in ihrer Grösse, Formgestaltung, Materialverwendung und technischen Konzeption keinen besonderen Ausnahmebedingungen, so dass die in dem jeweiligen Anwendungsgebiet bekannten Auswahlkriterien uneingeschränkt Anwendung finden können.

Weitere Einzelheiten, Merkmale und Vorteile des Gegenstandes der Erfindung ergeben sich aus der nachfolgenden Beschreibung der dazugehörigen Zeichnungen, in denen - beispielhaft - eine modulare Vorrichtung gemäss der vorliegenden Erfindung erläutert wird.

In den Zeichnungen zeigen:
- Figur 1: eine perspektivische Darstellung einer Beschichtungskammer, in der die Anordnung gemäss der vorliegenden Erfindung realisiert ist;
- Figur 2: ebenfalls eine perspektivische Darstellung des Gegenstandes nach Figur 1;
- Figur 3: eine erste Konfiguration der modularen Anordnung gemäss der vorliegenden Erfindung in perspektivischer Darstellung;
- Figur 4: eine zweite Konfiguration der modularen Anordnung gemäss der vorliegenden Erfindung in perspektivischer Darstellung;
- Figur 5: die Konfiguration nach Figur 4 von oben;
- Figur 6: eine dritte Konfiguration der modularen Anordnung gemäss der vorliegenden Erfindung in perspektivischer Darstellung;
- Figur 7: die Konfiguration nach Figur 6 von oben;
- Figur 8: eine vierte Konfiguration der modularen Anordnung gemäss der vorliegenden Erfindung in Darstellung von oben;
- Figur 9: eine fünfte Konfiguration der modularen Anordnung gemäss der vorliegenden Erfindung in Darstellung von oben;
- Figur 10: eine Konfiguration mit horizontalen Kathoden (sechste Konfiguration) in perspektivischer Darstellung;
- Figur 11: die Konfiguration mit horizontalen Kathoden nach Figur 10 von der Seite;
- Figur 12: die Konfiguration mit horizontalen Kathoden nach Figur 10 von oben;
- Figur 13: eine Konfiguration gemäss Figur 1, aber mit einer planaren Kathode, (siebte Konfiguration) in perspektivischer Darstellung;
- Figur 14: die Konfiguration nach Figur 13 von der Seite.

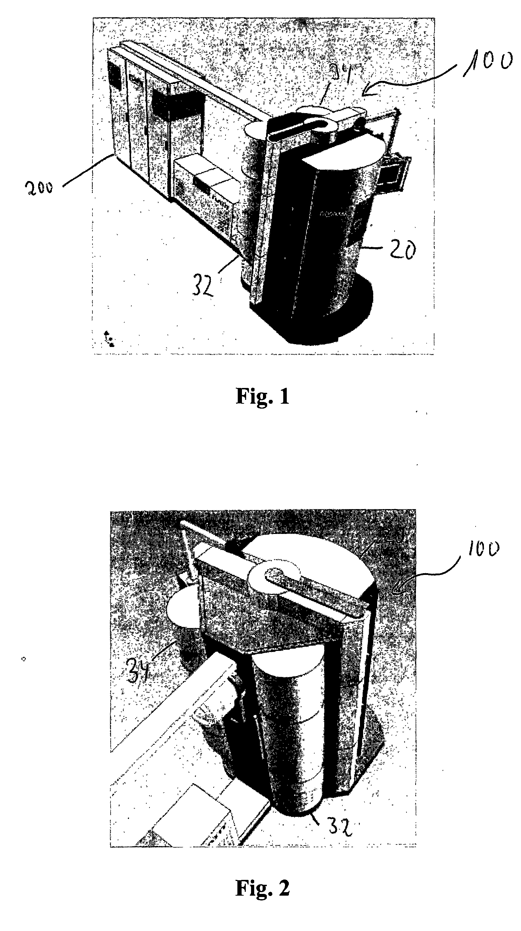

In Figur 1 ist eine Beschichtungsanlage als Gesamtsystem 100 mit der dazu gehörenden Elektronik 200 dargestellt. Das Kernstück des Systems ist die Beschichtungskammer, die - wie insbesondere aus Figur 2 ersichtlich - zwei oder mehrere türartige Einrichtungen 32, 34 an den Seiten aufweist. In diesen Einrichtungen können Kathoden - zusätzlich zu den bereits aus dem Stand der Technik bekannten, innenliegenden Aufnahmeeinrichtungen für Kathoden - aufgenommen werden und zwar in sehr unterschiedlichen Konfigurationen, von denen einige prinzipiell im nachfolgenden beschrieben werden.

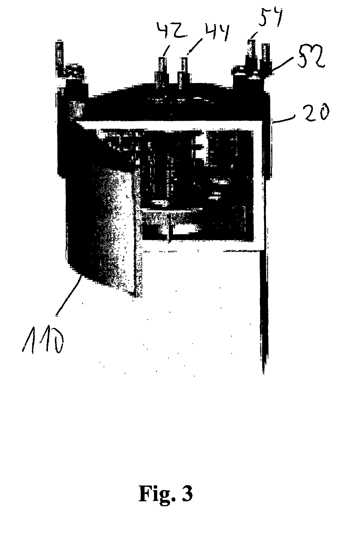

Als erste Konfiguration gibt Figur 3 die Vollkonfiguration für die modulare Anordnung nach dem hier beschriebenen Ausführungsbeispiel wieder. In der Kammer 100 mit einer Zugangstür 110 ist mittig eine Anordnung mit 4 Rotationskathoden 40, 42, 44, 46 ausgebildet. Weiterhin sind an den beschriebenen türartigen Einrichtungen 32, 34 an den Seiten jeweils zwei weitere Kathoden 48, 50, 52 und 54 untergebracht. Um die mittig angeordneten Kathoden herum ist ein drehtellerartiger Substrathalter angeordnet, auf dem eine Vielzahl von Substraten untergebracht ist. Bei der Beschichtung in dieser Konfiguration sind - aber nicht zwangsläufig - alle Kathoden allenfalls aus dem gleichen Material. In dieser Konfiguration wird dann die höchste Abscheidungsrate bzw. die grösste Beschichtungsrate erzielt.

Es sollte nur der Vollständigkeit darauf hingewiesen werden, dass die Rotationskathoden vorzugsweise in der Art betrieben werden, wie sie in dem zitierten Stand der Technik vorgeschlagen wurde, also mit einer Einrichtung zur gerichteten Ausbildung von Lichtbögen.

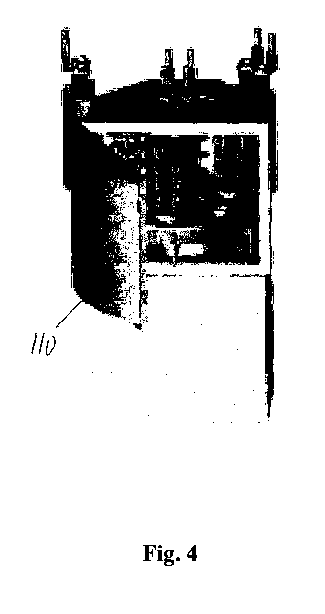

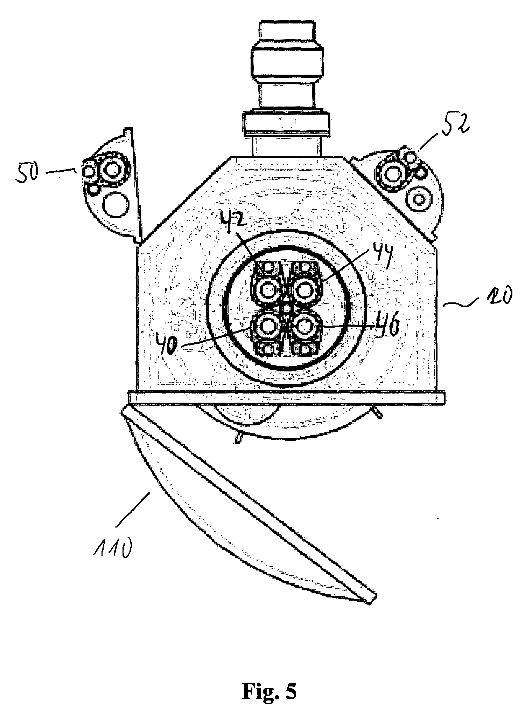

Die zweite Konfiguration gemäss Fig. 4 und 5 unterscheidet sich von der vorstehend beschriebenen ersten, auf den ersten Blick nur dadurch, dass neben den vier Kathoden 40, 42, 44 und 46 - wie gehabt - im Innenbereich jede der beiden Aussenstationen 32 und 34 nur mit jeweils einer Kathode 48 und 52 bestückt sind. Bei dieser Konfiguration werden mit einer hohen Abscheidrate im Innenbereich die Aussenkathoden 48 und 52 für Spezialaufgaben, z.B. zum Ionenätzen oder zum Abscheiden von Alternativschichten, verwendet. Solche Alternativschichten können Diamantbeschichtungen sein oder aber z.B. Schmierschichten. Es sollte betont werden, dass die Aussenkathoden gleichzeitig oder auch zeitlich getrennt von den Innenkathoden - oder auch zueinander - betrieben werden können, je nach der speziellen Beschichtungsaufgabe. Die anderen Merkmale der zweiten Konfiguration entsprechen der ersten.

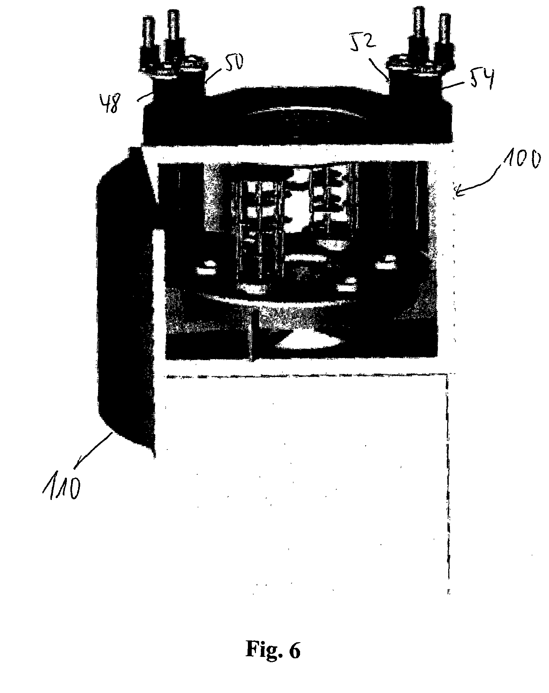

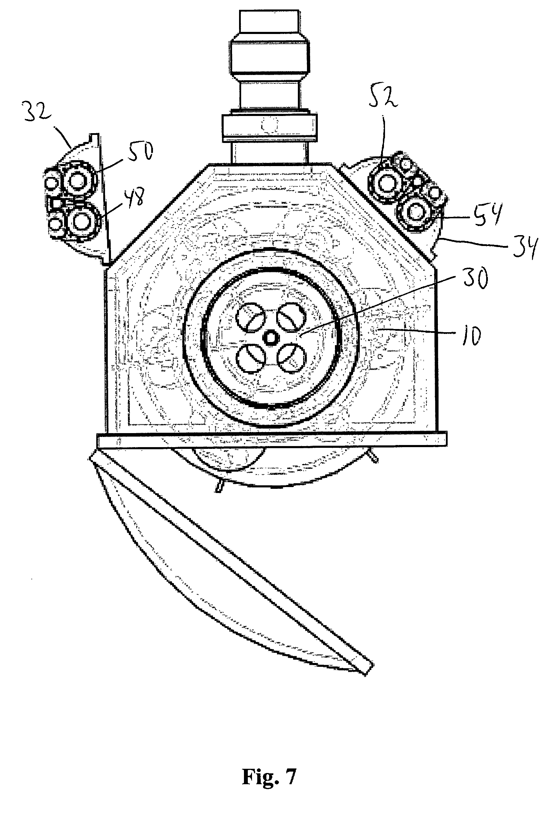

In der dritten Konfiguration gemäss Fig. 6 und 7 werden nur die beiden Aussenstationen 32 und 34 - jeweils mit zwei Kathoden - bestückt, um z.B. grosse Teile (Gesenke oder Kreissägeblätter etc.) von aussen beschichten zu können. Die Innenstation 30 bleibt in dieser Konfiguration frei. Die anderen Merkmale der dritten Konfiguration entsprechen der zweiten.

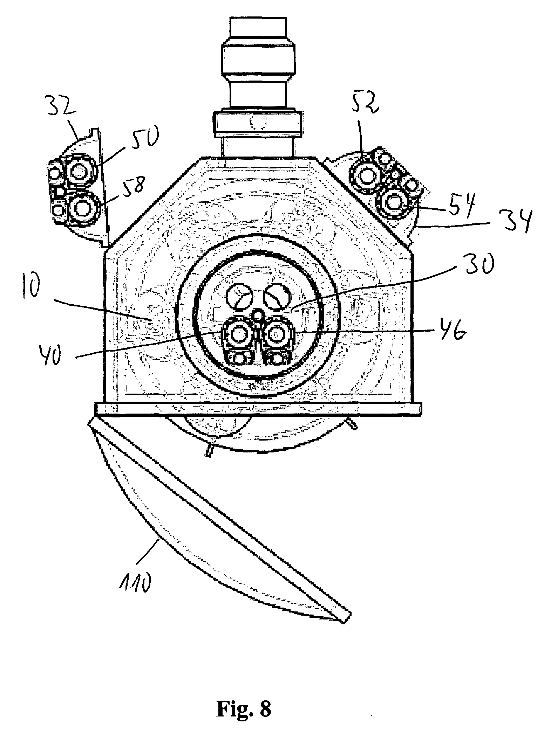

Die vierte Konfiguration gemäss Fig. 8 unterscheidet sich von der vorstehend beschriebenen ersten dadurch, dass neben den 4 Kathoden 48, 50, 52 und 54 im Aussenbereich auf der Innenstation 30 nur zwei Kathoden vorgesehen sind, nämlich die den Aussenstationen entfernt angeordneten Kathoden 40 und 46. Bei dieser Konfiguration wird die Beeinflussung der Plasmen zwischen den Kathoden der Aussenstationen 32 und 34 und denen der Innenstation 30 ausgeschlossen.

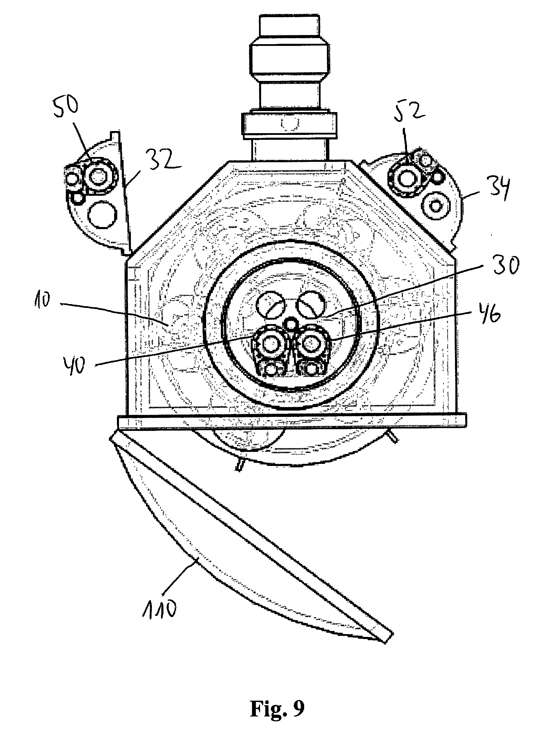

Die fünfte Konfiguration gemäss Fig. 9 unterscheidet sich von der vorstehend beschriebenen ersten dadurch, dass nur zwei Kathoden 48 und 52 im Aussenbereich und auf der Innenstation 30 auch nur zwei Kathoden vorgesehen sind, nämlich die den Aussenstationen entfernt angeordneten Kathoden 40 und 46. Dies ist eine weitere typische Konfiguration für eine Alternativbeschichtung, wobei wiederum die Kathoden der Aussenstationen und der Innenstation typischerweise unterschiedliche Materialien aufweisen.

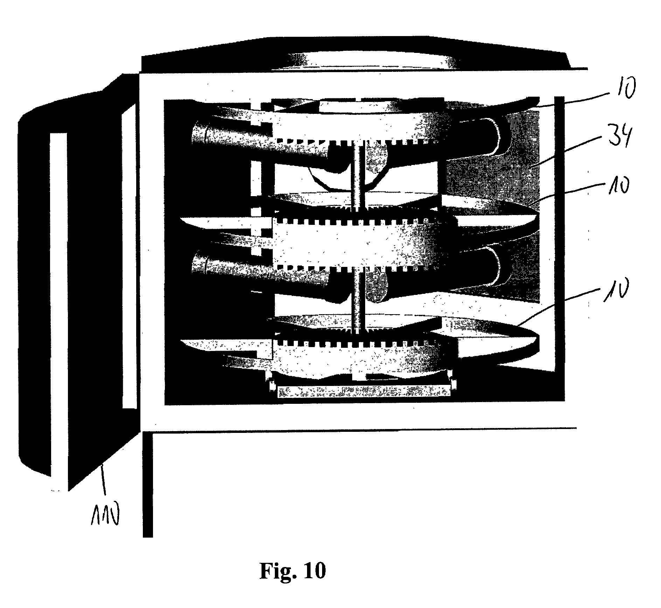

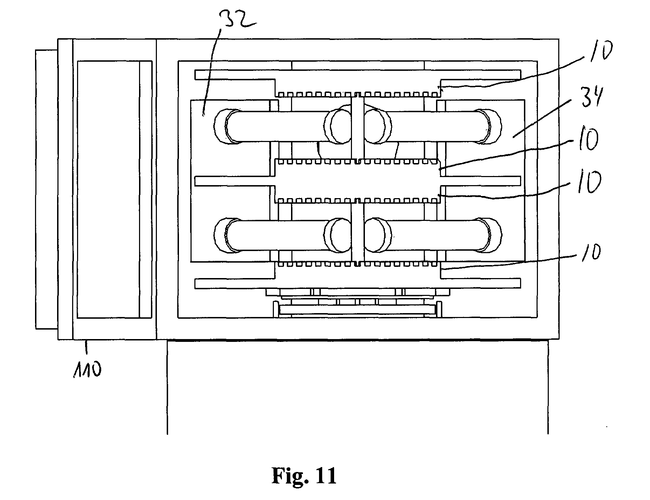

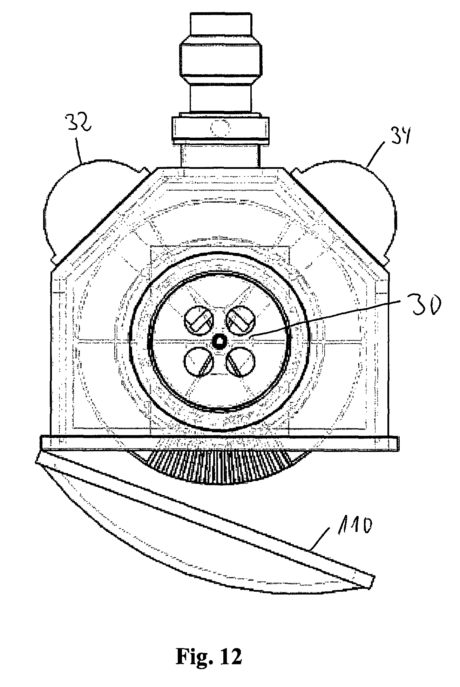

Überraschenderweise hat sich herausgestellt, dass die Konfiguration gemäss den Fig. 10 bis 12 besonders gut mit der erfindungsgemässen Anordnung hergestellt und betrieben werden kann. In dieser Konfiguration sind die beiden Aussenstationen 32 und 34 mit jeweils zwei horizontal angeordneten Rotationskathoden bestückt. In diesem Falle werden horizontale Wirkflächen ausgebildet, wie sie z.B. für Bandsägen und andere flache Gegenstände nützlich sind. In der vorliegenden Konfiguration werden mit den jeweils zwei Kathoden insgesamt vier Flächen beschichtet, wie in Fig. 10 dargestellt ist. Der besondere Vorteil dieser Konfiguration ist es, dass grosse Durchmesser beladbar sind und eine homogene Beschichtung an der Wirkfläche, z.B. die Freifläche von Bandsägen oder die Stirnfläche von Mold and dies, ohne schädliche Schichtdickenunterschiede ermöglicht werden.

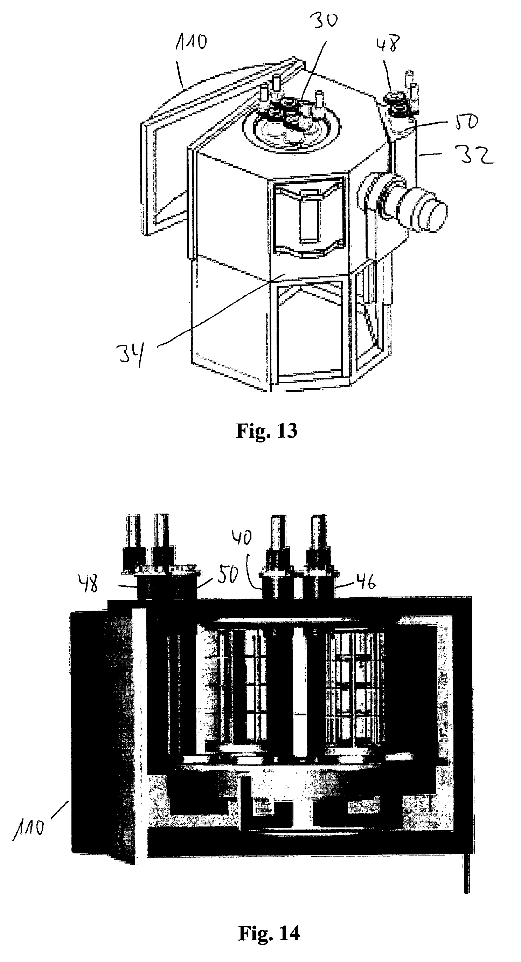

Die siebte Konfiguration gemäss Fig. 13 und 14 unterscheidet sich von der vorstehend beschriebenen ersten dadurch, dass neben den vier Kathoden 40, 42, 44 und 46 - wie gehabt - im Innenbereich nur eine Aussenstation 32 mit zwei Rotationskathoden 48 und 50 bestückt ist. Die andere Aussenstation 34 ist mit einer oder mehreren herkömmlichen, planaren Kathode bestückt.

Der Fachmann wird erkennen, dass die vorstehend beschriebenen Konfigurationen nicht abschliessend sind, sondern nur beispielhaft innerhalb des Bereichs der nachstehenden Patentansprüche dem Fachmann Ausführungen an die Hand geben.

## Patentansprüche

1. Modulare Vorrichtung zum Beschichten von Gegenständen (10)
- in einer Vakuumkammer (20), in der ein physikalisches Abscheideverfahren (PVD) durchgeführt werden kann, wobei
- die Vakuumkammer (20), zumindest ein Anodenmittel, zumindest eine Kathode (40, 42, 44, 46, 48, 50, 52, 54) umfasst, wobei mehrere Lichtbögen zwischen dem zumindest einen Anodenmittel und der zumindest einen Kathode (40, 42, 44, 46, 48, 50, 52, 54) gezündet werden können,
**dadurch gekennzeichnet, dass**
- eine Vielzahl von Aufnahmeeinrichtungen vorgesehen sind, in der die zumindest eine Kathode angeordnet werden kann,
- wobei eine erste Aufnahmeeinrichtung (30) zur Aufnahme von einer oder mehrerer Kathoden (40, 42, 44, 46) im wesentlichen in der Mitte der Vakuumkammer (20) und zumindest eine zweite Aufnahmeeinrichtung (32, 34) zur Aufnahme von zumindest einer Kathode (48, 50, 52, 54) am Rand der Vakuumkammer (20) vorgesehen sind.

2. Modulare Vorrichtung zum Beschichten von Gegenständen (10) nach Anspruch 1, **dadurch gekennzeichnet, dass** zwei Aufnahmeeinrichtungen (32, 34) zur Aufnahme von jeweils ein, zwei oder mehrere Kathoden (48, 50, 52, 54) am Rand der Vakuumkammer (20) vorgesehen sind.

3. Modulare Vorrichtung zum Beschichten von Gegenständen (10) nach Anspruch 1 oder 2, **dadurch gekennzeichnet, dass** die zweite Aufnahmeeinrichtung (32, 34) oder die zweiten Aufnahmeeinrichtungen (32, 34) zur Aufnahme von zumindest einer Kathode (48, 50, 52, 54) am Rand der Vakuumkammer (20) als abnehmbare und/oder aufklappbare Türen für die Vakuumkammer (20) ausgebildet sind.

4. Modulare Vorrichtung zum Beschichten von Gegenständen (10) nach einem der vorstehenden Ansprüche, **dadurch gekennzeichnet, dass** die zweite Aufnahmeeinrichtung (32, 34) oder die zweiten Aufnahmeeinrichtungen (32, 34) zur Aufnahme von zumindest einer Kathode (48, 50, 52, 54) am Rand der Vakuumkammer (20) zur Ausnahme wahlweise rotierenden Kathoden oder planaren Kathoden ausgebildet sind.

5. Modulare Vorrichtung zum Beschichten von Gegenständen (10) nach einem der vorstehenden Ansprüche, **dadurch gekennzeichnet, dass** die zweite Aufnahmeeinrichtung (32, 34) oder die zweiten Aufnahmeeinrichtungen (32, 34) zur Aufnahme von zumindest einer Kathode (48, 50, 52, 54) am Rand der Vakuumkammer (20) zur Ausnahme von im wesentlichen horizontal angeordneten, in die Vakuumkammer hineinragenden Kathoden ausgebildet sind.

6. Modulare Vorrichtung zum Beschichten von Gegenständen (10) nach einem der vorstehenden Ansprüche, **dadurch gekennzeichnet, dass** die genannte erste Aufnahmeeinrichtung (30) zur Aufnahme von einer oder mehrerer Kathoden (40, 42, 44, 46) in der Mitte der Vakuumkammer (20) zur Aufnahme von wahlweise ein bis vier Kathoden, vorzugsweise von rotierenden Kathoden ausgebildet ist.

7. System zum Beschichten von Gegenständen (10)
- in einer Vakuumkammer (20), in der ein physikalisches Abscheideverfahren (PVD) durchgeführt werden kann, mit
- einer Vakuumkammer (20), zumindest ein Anodenmittel,
- zumindest einer Kathode (40, 42, 44, 46, 48, 50, 52, 54),
- einem Substratanordnungsmittel (60) zur Aufnahme von einem oder mehreren zu beschichtenden Gegenständen (10), wobei ein Lichtbogen zwischen dem zumindest einen Anodenmittel und der zumindest einen Kathode (40, 42, 44, 46, 48, 50, 52, 54) gezündet werden kann,
**gekennzeichnet durch**
eine modulare Kathodenanordnung gemäss der Vorrichtung nach Anspruch 1 bis 6.

8. System zum Beschichten von Gegenständen (10) nach Anspruch 7, **dadurch gekennzeichnet, dass** die Vakuumkammer (20) als das Anodenmittel ausgebildet ist.

9. System zum Beschichten von Gegenständen (10) nach Anspruch 7 oder 8, **dadurch gekennzeichnet, dass** das Substratanordnungsmittel (60) als Drehkarussell ausgebildet ist.

10. System zum Beschichten von Gegenständen (10) nach Anspruch 9, **dadurch gekennzeichnet, dass** das Drehkarussell um die erste Aufnahmeeinrichtung (30) zur Aufnahme von einer oder mehrerer Kathoden (40, 42, 44, 46) herum ausgebildet ist.

11. System zum Beschichten von Gegenständen (10) nach Anspruch 9 oder 10, **dadurch gekennzeichnet, dass** auf dem Drehkarussell Drehwagen zur Aufnahme von zu beschichtenden Gegenständen und/oder zur Aufnahme von Satelliten zur Aufnahme von zu beschichtenden Gegenständen anordenbar sind.
